(19) Europäisches Patentamt
European Patent Office
Office européen des brevets

(11) **EP 3 147 575 B1**

(12) **EUROPÄISCHE PATENTSCHRIFT**

(45) Veröffentlichungstag und Bekanntmachung des Hinweises auf die Patenterteilung:
**07.08.2019 Patentblatt 2019/32**

(51) Int Cl.:
*F24D 19/10* (2006.01)     *G01K 17/06* (2006.01)
*G01K 17/00* (2006.01)     *G06F 17/50* (2006.01)
*F24F 5/00* (2006.01)

(21) Anmeldenummer: **16185415.3**

(22) Anmeldetag: **24.08.2016**

(54) **VERFAHREN UND VORRICHTUNG ZUR BESTIMMUNG EINES GEBÄUDEWÄRMEBEDARFS**

METHOD AND DEVICE FOR DETERMINING THE HEATING REQUIREMENTS OF A BUILDING

PROCEDE ET DISPOSITIF DESTINES A LA DETERMINATION DES BESOINS CALORIFIQUES D'UN BATIMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.09.2015 DE 102015116001**

(43) Veröffentlichungstag der Anmeldung:
**29.03.2017 Patentblatt 2017/13**

(73) Patentinhaber: **Techem Energy Services GmbH**
**65760 Eschborn (DE)**

(72) Erfinder:
• **Kähler, Arne**
**61350 Bad Homburg (DE)**
• **Schulz, Hans-Jürgen**
**61381 Friedrichsdorf (DE)**

(74) Vertreter: **Keil & Schaafhausen**
**Patent- und Rechtsanwälte PartGmbB**
**Friedrichstraße 2-6**
**60323 Frankfurt am Main (DE)**

(56) Entgegenhaltungen:
WO-A1-98/08179     DE-A1- 3 012 267
DE-A1- 10 057 834     DE-A1- 10 062 581
US-A1- 2007 235 550     US-A1- 2010 012 740

EP 3 147 575 B1

**Beschreibung**

Die Erfindung betrifft ein Verfahren und eine Vorrichtung zur Bestimmung eines Gebäudewärmebedarfs auf Basis von Wärmeverbrauchsdaten gemäß dem Oberbegriff des Anspruchs 1 bzw. des Anspruchs 11. Dies kann bspw. im Rahmen von Gebäudeklassifizierungen beispielsweise bei der Erstellung eines Gebäudeenergieausweises auf Basis der Wärmeverbrauchsdaten erfolgen. Dabei wird insbesondere ein Gesamtwärmeverlustkoeffizient ermittelt, vorzugsweise aus den die durch Raumheizung verbrauchte Wärmemenge anzeigenden Wärmeverbrauchsdaten. Mit dem beschriebenen Verfahren ist es möglich, einen mittleren Gebäudewärmeverlustkoeffizienten eines Gebäudes zu bestimmen, und damit auch den Wärmebedarf des gesamten Gebäudes zu ermitteln.

Der Gebäudewärmebedarf, der u.a. als Auslegungswert für die Raumbeheizung verwendet wird, wird üblicherweise durch ein Berechnungsverfahren ermittelt. Hierbei müssen die Wärmeleitfähigkeit und Dicke sämtlicher umhüllender Bauteile des Gebäudes, insbesondere Estrich, Wände, Dach, bekannt sein. Bei Bestandsbauten ist eine nachträgliche Ermittlung häufig nicht ohne weiteres möglich. Für die Wärmeleitfähigkeitswerte werden in einem solchen Fall typische Kennwerte verwendet, die Tabellen entnommen werden und von dem Baujahr des Gebäudes abhängen. Gebäudespezifische Lüftungsverluste, wie beispielsweise eine Fugenlüftung durch Undichtigkeiten, Wärmedrücken und dgl., werden üblicherweise durch Pauschalwerte berücksichtigt.

Eine weitere, derzeit praktizierte Möglichkeit besteht darin, den tatsächlich gemessenen Verbrauch eines Gebäudes zu ermitteln und witterungsbereinigt als Gesamtwärmebedarf zu verwenden.

Das vorbeschriebene Berechnungsverfahren hat jedoch den Nachteil, dass selbst bei genauer Kenntnis der verwendeten Baumaterialien der ermittelte Wärmebedarf ein rein theoretischer Wert bleibt, der Abweichungen in der Praxis nicht berücksichtigt. Diese Abweichungen können sich dadurch ergeben, dass von der Planung abweichende Materialien bei der Erstellung des Gebäudes verwendet wurden oder Verluste durch nicht fachgerecht angeschlossene Dämmschichten auftreten und damit Wärmebrücken entstehen. Wenn pauschale Wärmeleitfähigkeitswerte aus Bautabellen verwendet werden, welche zu dieser Zeit üblicherweise eingesetzte Materialien berücksichtigen, ist die Ungenauigkeit noch wesentlich größer. Insgesamt gibt es eine Vielzahl von Einflussgrößen, welche - wie die Praxis zeigt - teilweise signifikante Abweichungen von dem nur theoretisch berechneten Gebäudewärmebedarf ergeben.

Auch die bisher verwendeten Verfahren zur Ermittlung des Gebäudewärmebedarfs aus Verbrauchswerten sind unzureichend, weil das Nutzerverhalten einen sehr großen Einfluss auf den tatsächlichen Energieverbrauch eines Gebäudes hat und bisher nur unzureichend berücksichtigt wird. Insbesondere sind hier das Lüftungsverhalten und individuell gewünschte Raumtemperaturen zu nennen. Dies führt dazu, dass ein und dasselbe Gebäude bei unterschiedlicher Nutzerstruktur sehr unterschiedliche Verbrauchswerte haben kann. Außerdem wird üblicherweise der Verbrauch einer gesamten Heizperiode betrachtet. Innerhalb dieses Zeitraums ist das Gebäude jedoch einer Vielzahl von inneren und äußeren Einflüssen ausgesetzt, die typischerweise nicht berücksichtigt werden.

Die US 2010/0012740 A1 beschreibt ein Verfahren zum Abschätzen der Brennstoffzufuhr zu einem Boiler, bei dem eine mittlere Außentemperatur für eine zukünftige Zeitperiode P abgeschätzt wird und auf Grundlage dieser Abschätzung der Verbrauch des Gebäudes zum Erreichen einer gewünschten Innenraumtemperatur bestimmt wird. Dazu als charakteristische Größe des Gebäudes eine Energiesignatur $B_{heating}$ ermittelt, die den Gebäudeverbrauch in Abhängigkeit von der Differenz zwischen der Innentemperatur und der Außentemperatur in der Zeitspanne P beschreibt. Ferner wird eine stündliche Verteilung des Heizbedarfs $B_{heating\_H\_P}$ bestimmt, wobei hierfür auch eine stündliche Verteilung der Außentemperatur $T_{out\_H\_P}$ für die Periode P ermittelt wird. Die stündliche Verteilung des Heizbedarfs $B_{heating\_H\_P}$ kann von Stunde zu Stunde variieren.

In der US 2010/0012740 A1 wird ein Verfahren zur Ermittlung des Gesamtheizwärmebedarfs offenbart. Dazu werden unter anderem die Außentemperatur und der Heizmittelbedarf für einen Boiler über eine Zeitperiode beobachtet und daraus eine Heizleistung ermittelt, wobei sich eine durchschnittliche Heizleistung aus der Summe der in bestimmten Zeitsegmenten abgegebenen Wärmemenge ergibt. Ferner wird das thermische Gebäudegleichgewicht durch Berücksichtigung von Transmissions- und Lüftungsverluste (ausgelöst von Benutzern, Gebäudehülle und Klimakonditionen) zusammen mit der durch das Heizsystem zur Verfügung gestellten Wärme bestimmt. Dabei werden die Wärmeverluste durch Transmission und Lüftung als gemeinsamer Anteil $Q_{dh}$ neben dem Anteil für die Warmwasserherstellung $Q_{dw}$ betrachtet.

In der DE 100 62 581 A1 wird ein Verfahren zur Ermittlung des Wärmebedarfs eines Heizungssystems offenbart.

Aufgabe der Erfindung ist es, einen verlässlicheren Wert für den Gebäudewärmebedarf unter Verwendung von Wärmeverbrauchsdaten zu ermitteln, ohne dass die verwendeten Baumaterialien genau bekannt und Schwachstellen des Gebäudes im Vorfeld ermittelt werden müssen.

Diese Aufgabe wird erfindungsgemäß durch ein Verfahren mit den Merkmalen des Anspruchs 1 gelöst. Insbesondere ist bei einem Verfahren der eingangs genannten Art dazu vorgesehen, dass der Gesamtwärmeverlustkoeffizient in einen zeitlich invarianten Transmissionswärmedurchgangskoeffizient und einen zeitvarianten Lüftungswärmeverlustkoeffizient aufgeteilt wird.

Der Transmissionswärmedurchgangskoeffizient berücksichtigt im Wesentlichen die Wärmedurchlässigkeit der Gebäudehülle infolge Wärmeleitung und ist damit ein Maß für die thermische Qualität der wärmeleitenden Gebäudehülle. Der Lüftungswärmeverlustkoeffizient berücksichtigt dagegen zeitlich abhängige Lüftungsverluste, die das zeitlich abhängige Lüftungsverhalten der Nutzer sowie eine sich zeitlich ändernde Windlast oder sonstige zeitvariante, infiltrationsbedingte Störungsgrößen beinhalten.

Der Transmissionswärmedurchgangskoeffizient ist weitgehend unabhängig von dem Nutzerverhalten und damit auch zeitlich invariant. Mit dem zeitlich im Wesentlichen invarianten Transmissionswärmedurchgangskoeffizienten und dem zeitvarianten Lüftungswärmeverlustkoeffizienten können der Wärmebedarf eines Gebäudes für unterschiedliche Außen- und Innentemperaturen leicht ermittelt und Schwachstellen in der Gebäudehülle und Besonderheiten im Lüftungsverhalten der Nutzer erkannt werden.

Es hat sich als besonders vorteilhaft erwiesen, den Transmissionswärmedurchgangskoeffizienten separat für Räume mit (insbesondere ausschließlich) Außenluftkontakt (d.h. insbesondere Räume ohne Erdkontakt) und für Räume mit mindestens teilweisem Erdkontakt zu berechnen, da die Verlustwärmeströme und die Außentemperaturabhängigkeit in diesen Räumen unterschiedlich sind. Auch innenliegende Räume können insbesondere den Räumen mit nur Außenluftkontakt zugerechnet werden, wenn sie keinen Erdkontakt aufweisen. Erfindungsgemäß besteht die Möglichkeit, den Gesamtwärmeverlustkoeffizienten rechnerisch aus der Ableitung der für die Raumheizung aufgewandten Wärmemenge insbesondere pro Messintervall nach der Außentemperatur zu ermitteln. Alternativ oder zusätzlich kann der Gesamtwärmeverlustkoeffizient rechnerisch aus dem Verhältnis der zeitlichen Ableitung der für die Raumheizung aufgewandten Wärmemenge pro Messintervall und der zeitlichen Ableitung der Außentemperatur ermittelt wird. Die benötigten Messgrößen lassen sich einfach erfassen, wie den im Weiteren offenbarten Formeln für die Berechnung entnommen werden kann.

Ferner ist es möglich, den Gesamtwärmeverlustkoeffizient graphisch durch Bestimmung des Anstiegs einer linearisierten Kennlinie der Verlustleistung über der Außentemperatur bzw. einer Außentemperaturänderung ermittelt wird. Auch dies ist im Weiteren noch durch Formeln offenbart und bietet die Möglichkeit, eine graphische Auswertung von Messpunkten unter Anwendung einer Regression vorzunehmen.

Gemäß dem vorgeschlagenen Verfahren wird ausgehend von einem insbesondere auf Basis der Wärmeverbrauchsdaten gemessenen oder ermittelten Gebäudewärmeverlust ein Gesamtwärmeverlustkoeffizient bestimmt. Anschließend wird der Transmissionswärmedurchgangskoeffizient unter Verwendung des Gesamtwärmeverlustkoeffizienten und eines (bspw. auch geschätzten) minimalen Lüftungswärmekoeffizienten berechnet. Aus dem Gesamtwärmeverlustkoeffizient und dem Transmissionswärmedurchgangskoeffizient wird anschließend der von dem Nutzerverhalten und Witterungseinflüssen abhängige, und daher zeitvariante, Lüftungswärmeverlustkoeffizient berechnet. Der Transmissionswärmedurchgangskoeffizient wird unterteilt in einen außentemperaturunabhängigen und außentemperaturabhängigen Teil. Hierfür stehen insbesondere je nach Art der Verbrauchsdaten unterschiedliche Berechnungs- beziehungsweise Ermittlungsverfahren zur Verfügung, auf welche später noch im Detail eingegangen wird. Alle diese Verfahren bilden eine besonders bevorzugte Ausführungsform der vorliegenden Erfindung.

Für die Erfassung der Wärmeverbrauchs- und Temperaturdaten kommen erfindungsgemäß sowohl zentrale Messeinrichtungen, insbesondere Wärmezähler, als auch dezentrale Messeinrichtungen wie etwa Heizkostenverteiler oder auch Rauchwarnmelder in Frage. Mit Hilfe der zentralen Wärmezähler wird die zur Raumbeheizung abgegebene Wärmemenge nach der Wärmeerzeugung erfasst, wobei die Messeinrichtungen gegebenenfalls das Erfassen der in die jeweiligen Gebäudeteile transportierten Wärmemenge ermöglichen, d.h. eine separate Erfassung für innenliegende Räume und für Räume mit ausschließlich Außenluftkontakt oder mit mindestens teilweisem Erdkontakt. Es ist jedoch auch denkbar, den Wärmeverlust einzelner Gebäudeteile relativ zum Gesamtwärmeverlust auf Basis der Verteilrechnung mittels Heizkostenverteilern abzuschätzen. Gegebenenfalls kann dafür die zuvor erwähnte zentrale Erfassung der abgegebenen Wärmemenge auch kombiniert werden mit einer dezentralen Erfassung, bei der die Wärmeverbrauchsdaten durch dezentrale Messeinrichtungen, insbesondere an den Heizkörpern montierte Heizkostenverteiler, die zur Beheizung abgegebene Wärmemenge erfasst werden. Dazu erfassen die Messeinrichtungen die Wärmemenge beziehungsweise den Wärmeverbrauch einzelner Heizkörper, Heizstränge, Gebäudeteile und/oder Räume, die in ihrer Summe die im gesamten Gebäude abgegebene Wärmemenge ergeben. Natürlich können als dezentrale Messeinrichtungen auch Wärmemengenzähler eingesetzt werden, die einzelne Heizungsstränge oder Räume erfassen. Die dezentralen, ggf. auch die zentralen, Messsysteme sind vorzugsweise mit Funkübertragungseinrichtungen ausgestattet, um ihre Messwerte an Datensammelstellen (Datensammler) zu übertragen, beispielsweise im Rahmen bestehender Ablesesysteme zur Heizkostenerfassung mit elektronischen Heizkostenverteilern. Das System lässt sich natürlich auch mit drahtgebundenen Systemen realisieren. Die dezentralen Messeinrichtungen können auch vollständig anstelle der zentralen Messeinrichtungen Anwendung finden.

Besonders vorteilhaft ist es, wenn erfindungsgemäß zur Bestimmung des zeitinvarianten Transmissionswärmedurchgangskoeffizienten und des zeitvarianten Lüftungswärmeverlustkoeffizienten Messdaten lediglich aus weitgehend stationären Systemzuständen ausgewählt werden. Diese Phase stationärer Systemzustände können insbesondere durch Überwachung der Rauminnentemperaturen und deren Gradienten über die Zeit, d.h. deren zeitliche Ableitung, identifiziert werden. Wenn sich die Rauminnentemperaturen mit der Zeit in einer vorgegebenen Zeitspanne nicht oder nur gering ändern, ist von einem stationären Zustand in dem betrachteten Gebäude bzw. Gebäudeteil auszugehen, so dass insbesondere der Transmissionswärmedurchgangskoeffizient und der Lüftungswärmeverlustkoeffizient verlässlich ermittelt werden können. Dies ist auch deshalb wichtig, weil für deren Ermittlung eine Mittelung über die Zeit vorgenommen wird und Veränderungen der Messgrößen in einem nicht stationären Zeitraum die Ergebnisse verfälschen würden.

In einer besonders bevorzugten Anwendung des erfindungsgemäßen Verfahrens wird vorgeschlagen, dass insbesondere unter Zugrundelegung der aus stationären Systemzuständen ermittelten Wärmeverlustkoeffizienten der zeitliche Verlauf des Lüftungswärmeverlustkoeffizienten beobachtet und so auf das Nutzerverhalten geschlossen wird. Diese Erkenntnisse können verwendet werden, um den Nutzer über sein Verhalten zu informieren. Ferner kann anhand zuvor festgelegter, typischer Verhaltensmuster ermittelt werden, wenn das Nutzerverhalten zu einem überhöhten Energieverbrauch führt und der Nutzer darauf hingewiesen werden.

Durch die insgesamt erhobenen Messwerte (Verbrauchswerte, Innentemperaturen gegebenenfalls sogar der einzelnen beziehungsweise zu Gruppen zusammengefassten Räume, Außentemperatur und/oder Bodentemperatur des Erdreichs sowie gegebenenfalls weiterer Informationen wie Raumsolltemperatur oder Ventilstellung der Heizflächenventile) ist es erfindungsgemäß ferner möglich, zeitlich abhängige Wärmeeintragsprofile des Gebäudes zu erstellen, welche helfen, bestimmte Einflüsse des Energieverbrauchs zu erkennen und Gegenmaßnahmen, sei es durch technische Verbesserungen und/oder Änderung des Nutzerverhaltens, zu erreichen.

Die Erfindung bezieht sich ferner auf eine Vorrichtung zur Bestimmung eines Gebäudewärmebedarfs, insbesondere im Rahmen von Gebäudeklassifizierungen beispielsweise bei der Erstellung eines Gebäudeenergieausweises auf Basis von einem Gesamtwärmeverlustkoeffizient, welcher vorzugsweise aus den durch die Raumheizung verbrauchten Wärmemenge anzeigenden Wärmeverbrauchsdaten ermittelt wird. Die Vorrichtung ist mit einer zentralen Erfassungs- und Verarbeitungseinheit ausgestattet, welche Schnittstellen zum Anschließen von Messeinrichtungen zur Ermittlung des Wärmeverbrauchs und eine Recheneinheit aufweist. Die Recheneinheit ist dazu eingerichtet, die von den Messeinrichtungen erfassten Messdaten zu empfangen, zu speichern und weiterzuverarbeiten, indem ein Gesamtwärmeverlustkoeffizient ermittelt wird. Erfindungsgemäß wird mit der dazu eingerichteten Recheneinheit dieser Gesamtwärmeverlustkoeffizient in einen zeitlich invarianten Transmissionswärmedurchgangskoeffizienten mit einem außentemperaturabhängigen und einen außentemperaturunabhängigen Teil und einen zeitlich varianten Lüftungswärmeverlustkoeffizienten aufgeteilt.

Die Recheneinheit ist durch Programmierung insbesondere zur Durchführung des zuvor beschriebenen Verfahrens oder einzelner Verfahrensschritte eingerichtet und kann daher besonders gut zur Durchführung des vorbeschriebenen Verfahrens verwendet werden.

Gemäß einer bevorzugten Ausführungsform der Erfindung sind als Messeinrichtungen Wärmezähler, Heizkostenverteiler und/oder Temperaturfühler an die Schnittstellen angeschlossen. Die Temperaturfühler sind dazu vorgesehen, Rauminnentemperaturen, die Außentemperatur und/oder die Grund- beziehungsweise Bodentemperatur zu messen. Die Temperaturfühler können Bestandteil von Heizkostenverteilern oder Rauchwarnmeldern sein.

Durch die erfindungsgemäß vorgeschlagene Ermittlung der Kennwerte "Transmissionswärmedurchgangskoeffizient" und "Lüftungswärmeverlustkoeffizient" werden den Wärmeverlust charakterisierende Kennwerte bestimmt, die eine vergleichende Beurteilung der energetischen Qualität der Gebäudehülle unterschiedlicher Gebäude auf zuverlässiger Weise aufgrund von Verbrauchsdaten ermöglichen. Einer der Kennwerte, nämlich der Transmissionswärmedurchgangskoeffizient, blendet das Nutzerverhalten weitestgehend aus. Dabei ist es möglich, diesen energetischen Gebäudekennwert ohne Kenntnis der Wandkonstruktion, der verwendeten Baumaterialien und möglicher Abweichungen in der Ausführung von einem Bauplan zu bestimmen. Der zweite Kennwert Lüftungswärmeverlustkoeffizient berücksichtigt dann die zeitvarianten Einflüsse, die typischer Weise durch das Nutzerverhalten und Wittereinflüsse dominiert sind.

Besonders vorteilhaft bei dem vorgeschlagenen Verfahren ist, dass aus der Heizkostenerfassung vorhandene Messeinrichtungen weitestgehend genutzt werden können und Zusatzeinrichtungen nur für die Auswertung der Messergebnisse notwendig sind. Gegebenenfalls ist es höchstens vorteilhaft noch weitere Temperatursensoren zu installieren, falls aus den Verbrauchsmessdaten die Rauminnentemperaturwerte und gegebenenfalls die Bodentemperatur nicht genau bestimmt werden können. Ein Außentemperaturfühler ist im Rahmen der Heizungsanlage zumeist vorhanden.

Insbesondere ist die Recheneinheit der Vorrichtung dazu eingerichtet, das zuvor beschriebene Verfahren oder Teile hiervon auszuführen.

Weitere Vorteile, Merkmale und Anwendungsmöglichkeiten der vorliegenden Erfindung ergeben sich auch aus der nachfolgenden Beschreibung eines Ausführungsbeispiels und der Zeichnung. Dabei bilden alle beschriebenen und/oder bildlich dargestellten Merkmale für sich oder in beliebiger Kombination den Gegenstand der vorliegenden Erfindung, auch unabhängig von ihrer Zusammenfassung in den Ansprüchen oder deren Rückbezügen.

Es zeigen:

Fig. 1    schematisch ein Haus mit verschiedenen Räumen zur Erläuterung der theoretischen Grundlagen des Verfahrens;

Fig. 2    schematisch eine erfindungsgemäße Vorrichtung zur Durchführung des Verfahrens;

Fig. 3    ein Flussdiagramm des erfindungsgemäß vorgeschlagenen Verfahrens und

Fig. 4    ein Diagramm zur graphischen Analyse der erhobenen Daten.

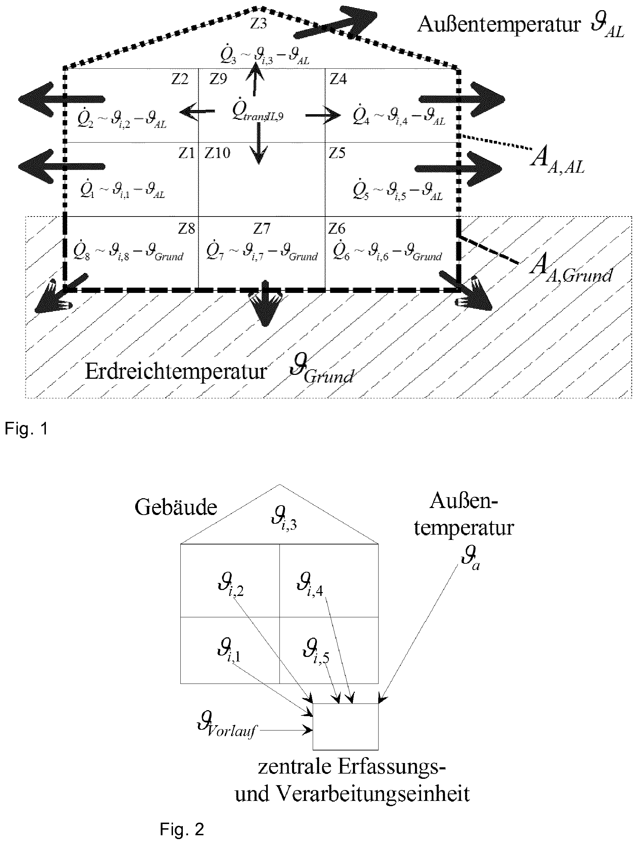

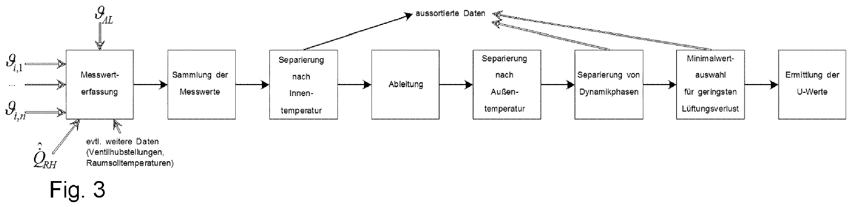

Figur 1 stellt schematisch ein Gebäude mit einem die Räume Z6, Z7, Z8 aufweisenden Keller dar, der sich im Erdreich befindet, einem Erdgeschoss mit den Räumen Z1, Z10, Z5, mit einem ersten Stock mit den Räumen Z2, Z9, Z4 und mit einem Dach mit dem Raum Z3. Die Räume des Erdgeschosses, des ersten Stocks und des Daches weisen abgesehen von den innenliegenden Räumen Z9 und Z10 jeweils eine Außenfläche zur Außenluft auf. Der Keller weist eine Außenfläche zum Erdreich auf.
Die auch als Gebäudehülle bezeichnete Außenfläche ist für den Außenbereich zur Außenluft gepunktet und für den Außenbereich zum Erdreich gestrichelt dargestellt. Die für die Durchführung des erfindungsgemäß vorgeschlagenen Verfahrens relevanten Transmissionsströme, welche zu Transmissionsverlusten durch die Gebäudeaußenhülle führen, sind durch fett dargestellte Pfeile repräsentiert, die jeweils einem Transmissionsverlust Q dieses Zimmers zugeordnet sind. Die Transmissionsströme zwischen einzelnen Räumen und damit auch die gesamten Transmissionsströme von innenliegenden Räumen müssen nicht betrachtet werden, da diese in den Transmissionsverlusten durch die Gebäudehülle automatisch mit enthalten sind.
Als weitere Messgröße geht in das vorgeschlagene Verfahren die Außentemperatur $\vartheta_A$ ein, die von einem zentralen Außentemperatursensor ermittelt und von der Heizungsanlage oder von einem weiteren Mess- und Regelsystem verwendet wird. Die Erdreichtemperatur $\vartheta_{Grund}$ wird entweder durch einen geeigneten Sensor ermittelt oder abgeschätzt, wobei bei einer Abschätzung ein realistischer Temperaturwert von $\vartheta_{Grund}=12°C$ für das nördliche Mitteleuropa zugrunde gelegt werden kann.
Die Wärmemengen, die zur Bestimmung des Gebäudewärmeverlustes Q herangezogen werden, sind proportional zu den Temperaturen der einzelnen Räume $\vartheta_i$, die durch Heizkostenerfassungssysteme oder Rauchwarnmelder oder auch mittels gesonderter Temperatursensoren gemessen werden, und der Differenz zwischen Innen- und Außenbeziehungsweise Innen- und Erdreichtemperatur.
In Figur 2 ist das System zur Messwerterfassung und Durchführung des Verfahrens schematisch dargestellt. In den einzelnen Räumen des Gebäudes werden die Innentemperaturen $\vartheta_i$ gemessen, welche ein Maß für die in diesem Raum verbrauchte Wärmemenge ist. Diese Temperaturen $\vartheta_i$ können insbesondere durch Heizkostenverteiler oder Rauchwarnmelder oder auch mittels gesonderter Temperatursensoren erfasste Temperaturen sein. Ferner werden die Außentemperatur $\vartheta_a$, gegebenenfalls auch die Erdreichtemperatur $\vartheta_{Grund}$ (in Figur 2 nicht dargestellt) und die Vorlauftemperatur der Heizungsanlage $\vartheta_{Vorlauf}$ (welche zur Ermittlung der verbrauchten Wärmemenge an einzelnen Heizkörpern verwendet werden kann) durch eine zentrale Erfassungs- und Verarbeitungseinrichtung erfasst und dort zur weiteren Verarbeitung gespeichert. Wie nachfolgend noch ausführlich beschrieben wird, kann mit Hilfe der erfassten Wärmemengen durch Beobachtungen und Auswertung über einen längeren Zeitraum der Lüftungs- und Transmissionsverlustanteil abgeschätzt und die resultierenden Transmissionswärme- und Lüftungswärmeverlustkoeffizienten ermittelt werden.
Alle in Fig. 2 dargestellten Messdaten werden automatisiert, beispielsweise drahtgebunden oder per Funk, zusammengetragen und lassen sich zeitlich exakt orten. Hierdurch ist es möglich, einen relativ kurzen Beobachtungszeitraum zu wählen. Durch wiederholte Messzyklen zu unterschiedlichen Tageszeiten und Vergleiche lassen sich äußere Einflüsse und Nutzerverhalten erkennen und bei der Bewertung der Daten eliminieren.
Dieses grundsätzliche Vorgehen ist in Fig. 3 dargestellt, welches den Ablauf des erfindungsgemäßen Verfahrens in einer Verfahrensvariante verdeutlicht.
Nachfolgend wird das vorgeschlagene Verfahren anhand einer besonders bevorzugten Ausführungsform beschrieben, bei der die Ermittlung der Transmissions- und Lüftungswärmeverlustkoeffizienten auf Basis einer gebäudezentralen Wärmeerfassung für die Raumbeheizung in Kombination mit einer gebäudedezentralen Raumheizwärmeerfassung, bspw. mittels Heizkostenverteilern, erfolgt.
Zunächst werden die dem Verfahren zugrundeliegenden theoretischen Grundlagen erläutert.
Der Wärmeverlust $\dot{Q}_{Verlust}$ für die Raumbeheizung eines Gebäudes setzt sich zusammen aus einem Transmissionsanteil $\dot{Q}_{trans}$ (Wärmeleitung) durch die Gebäudehülle und einem infiltrationsbedingten Anteil $\dot{Q}_{inf}$ (freie und mechanische Außenlüftung):

$$\dot{Q}_{Verlust} = \dot{Q}_{trans} + \dot{Q}_{inf} \,.$$

Der Transmissionsanteil $\dot{Q}_{trans}$ enthält die Transmissionsverluste an die Außenluft $\dot{Q}_{trans,AL}$ und in das angrenzende Erdreich $\dot{Q}_{trans,Grund}$:

$$\dot{Q}_{trans} = \dot{Q}_{trans,AL} + \dot{Q}_{trans,Grund} \; .$$

Somit folgt für den gesamten Wärmeverlust des Gebäudes:

$$\dot{Q}_{Verlust} = \dot{Q}_{trans,AL} + \dot{Q}_{trans,Grund} + \dot{Q}_{\inf} \; .$$

Für die Transmissionswärmeverluste $\dot{Q}_{trans}$ eines Gebäudes gilt, je nachdem, ob der Wärmeverlust durch Abgabe an die Außenluft (AL) oder das Erdreich (Grund) erfolgt:

$$\dot{Q}_{trans,AL} = u_{trans,AL} * A_{A,AL} * \left(\vartheta_{innen,AL} - \vartheta_A\right)_{AV}$$

bzw.

$$\dot{Q}_{trans,Grund} = u_{trans,Grund} * A_{A,Grund} * \left(\vartheta_{innen,Grund} - \vartheta_{Grund}\right)_{AV},$$

mit

| | |
|---|---|
| $u_{trans,AL}$ | Wärmedurchgangskoeffizient, bezogen auf die Außenfläche $A_{A,AL}$ der Außenluft berührenden Gebäudeteile [W/K*m$^2$]; |
| $A_{A,AL}$ | Außenfläche der Außenluft berührenden Gebäudeteile [m$^2$]; |
| $(\vartheta_{innen,AL} - \vartheta_A)_{AV}$ | mittlere Temperaturdifferenz zwischen Innenluft- und der Außenlufttemperatur der Räume, die Außenwände mit (insbesondere nur) Außenluftkontakt aufweisen [K]; |
| $u_{trans,Grund}$ | Wärmedurchgangskoeffizient, bezogen auf die Außenfläche $A_{A,Grund}$ der Erdreich berührenden Gebäudeteile; |
| $A_{A,Grund}$ | Außenfläche der Erdreich berührenden Gebäudeteile [m$^2$]; |
| $(\vartheta_{innen,Grund} - \vartheta_{Grund})_{AV}$ | mittlere Temperaturdifferenz zwischen Innenlufttemperatur und Erdreichtemperatur der Räume, die Außenwände mit Erdkontakt aufweisen. |

Für die Lüftungswärmeverluste $\dot{Q}_{\inf}$ gilt in ähnlicher Weise:

$$\dot{Q}_{\inf} = c_{Luft} * \rho_{Luft} * \overline{h}_{NE} * \lambda_{LW} * \sum_{R\ddot{a}ume} A_{N,R\ddot{a}ume} * \left(\vartheta_{innen} - \vartheta_A\right)_{AV},$$

mit

| | |
|---|---|
| $(\vartheta_{innen} - \vartheta_A)_{AV}$ | mittlere Temperaturdifferenz zwischen Innenluft- und Außenlufttemperatur der Räume [K]; |
| $c_{Luft}, \rho_{Luft}$ | Stoffwerte von Luft: spezifische Wärmekapazität und Dichte; |
| $\overline{h}_{NE}$ | mittlere Geschosshöhe der belüfteten Räume des Gebäudes [m]; |
| $\displaystyle\sum_{R\ddot{a}ume} A_{N,R\ddot{a}ume}$ | Nutzfläche der betrachteten Räume bzw. Gebäudeteile [m$^2$]; |
| $\lambda_{LW}$ | mittlerer Luftwechsel im Gebäude [1/h]. |

Wird der Quotient

$$\frac{\dot{Q}_{\inf}}{A_{A,AL} * \left(\vartheta_{innen} - \vartheta_A\right)_{AV}} =$$

$$\frac{\dot{Q}_{\inf,AL} + \dot{Q}_{\inf,IL} + \dot{Q}_{\inf,Grund}}{A_{A,AL} * \left(\vartheta_{innen} - \vartheta_A\right)_{AV}} = \frac{c_{Luft} * \rho_{Luft} * \overline{h}_{NE} * \lambda_{LW} * \sum_{R\ddot{a}ume} A_{N,R\ddot{a}ume}}{A_{A,AL}}$$

in Analogie zum Transmissionswärmeverlust als Lüftungswärmeverlustkoeffizient definiert, also

$$u_{\text{inf}} = \frac{\dot{Q}_{\text{inf}}}{A_{A,AL} * \left(\vartheta_{innen} - \vartheta_A\right)_{AV}} = \frac{\dot{Q}_{\text{inf},AL} + \dot{Q}_{\text{inf},IL} + \dot{Q}_{\text{inf},Grund}}{A_{A,AL} * \left(\vartheta_{innen} - \vartheta_A\right)_{AV}} = u_{\text{inf},AL} + u_{\text{inf},IL} + u_{\text{inf},Grund} \text{,}$$

$$u_{\text{inf}} = \frac{\dot{Q}_{\text{inf}}}{A_{A,AL} * \left(\vartheta_{innen} - \vartheta_A\right)_{AV}} = \frac{\dot{Q}_{\text{inf},AL} + \dot{Q}_{\text{inf},IL} + \dot{Q}_{\text{inf},Grund}}{A_{A,AL} * \left(\vartheta_{innen} - \vartheta_A\right)_{AV}} = \frac{c_{Luft} * \rho_{Luft} * \overline{h}_{NE} * \lambda_{LW} * \sum\limits_{R\ddot{a}ume} A_{N,R\ddot{a}ume}}{A_{A,AL}}$$

kann für die Lüftungswärmeverluste für außen liegende Räume (ohne Erdreichkontakt)

$$\dot{Q}_{\text{inf},AL} = u_{\text{inf},AL} * A_{A,AL} * \left(\vartheta_{innen,AL} - \vartheta_A\right)_{AV} =$$
$$c_{Luft} * \rho_{Luft} * \overline{h}_{NE} * \lambda_{LW,AL} * \sum\limits_{R\ddot{a}ume,AL} A_{N,R\ddot{a}ume,AL} * \left(\vartheta_{innen,AL} - \vartheta_A\right)_{AV} \text{,}$$

für innen liegende Räume (ohne Erdreichkontakt)

$$\dot{Q}_{\text{inf},IL} = u_{\text{inf},AL} * A_{A,AL} * \left(\vartheta_{innen,IL} - \vartheta_A\right)_{AV} =$$
$$c_{Luft} * \rho_{Luft} * \overline{h}_{NE} * \lambda_{LW,IL} * \sum\limits_{R\ddot{a}ume,IL} A_{N,R\ddot{a}ume,IL} * \left(\vartheta_{innen,IL} - \vartheta_A\right)_{AV}$$

und für außen liegende Räume mit Erdreichkontakt

$$\dot{Q}_{\text{inf},Grund} = u_{\text{inf},Grund} * A_{A,AL} * \left(\vartheta_{innen,Grund} - \vartheta_A\right)_{AV} =$$
$$c_{Luft} * \rho_{Luft} * \overline{h}_{NE} * \lambda_{LW,Grund} * \sum\limits_{R\ddot{a}ume,Grund} A_{N,R\ddot{a}ume,Grund} * \left(\vartheta_{innen,Grund} - \vartheta_A\right)_{AV}$$

geschrieben werden.

Die in den vorstehenden Gleichungen benötigten mittleren - nutzflächenbezogenen - Temperaturdifferenzen können wie folgt ermittelt werden.

Die mittlere Temperaturdifferenz zwischen Innenluft- und Außenlufttemperatur der Räume, die Außenwände mit Außenluftkontakt aufweisen (außen liegende Räume, aber ohne Erdreichkontakt), ergibt sich aus

$$\left(\vartheta_{innen,AL} - \vartheta_A\right)_{AV} = \left(\overline{\vartheta}_{innen,AL} - \vartheta_{A,AV}\right) = \left(\frac{1}{\sum\limits_k A_{N,AL,k}} \sum\limits_k A_{N,AL,k} \cdot \vartheta_{innen,AL,AV,k}\right) - \vartheta_{A,AV} \text{,}$$

mit

$\vartheta_{innen,AL,AV,k}$     über $\Delta_t$ zeitlich gemittelte Innentemperatur der Räume k, die Außenwände mit Außenluftkontakt aufweisen [°C];

$\vartheta_{A,AV}, \overline{\vartheta}_A$     über $\Delta_t$ zeitlich gemittelte Außentemperatur [°C];

$\Delta_t$     Messzeitraum;

$A_{N,AL,k}$     Nutzfläche der Räume, die Außenwände mit Außenluftkontakt (ohne Erdreichkontakt) aufweisen [m$^2$].

Für die zeitlich gemittelte und nutzflächengemittelte Innentemperatur der Räume, die Außenwände mit Außenluftkontakt aufweisen (außen liegende Räume ohne Erdreichkontakt), gilt:

$$\vartheta_{innen,AL,AV} = \overline{\vartheta}_{innen,AL} = \frac{1}{\displaystyle\sum_{k} A_{N,AL,k}} \sum_{k} A_{N,AL,k} \cdot \vartheta_{innen,AL,AV,k} \cdot$$

Für alle anderen Räume kann analog verfahren werden.

Für die mittlere Innentemperatur gilt:

$$\vartheta_{innen,AV} = \overline{\vartheta}_{innen} = \frac{1}{\displaystyle\sum_{k} A_{N,k}} \sum_{k} A_{N,k} \cdot \vartheta_{innen,AV,k}$$

mit

$\vartheta_{innen,AV,k}$  über $\Delta_t$ zeitlich gemittelte Innentemperatur der Räume k [°C];
$\Delta_t$  Messzeitraum;
$A_{N,k}$  Nutzfläche des Raumes k [m²].

Unter Berücksichtigung o.g. Koeffizienten und der Bezugsflächen kann der Wärmeverlust eines Gebäudes somit wie folgt berechnet werden:

$$\dot{Q}_{Verlust} = \dot{Q}_{trans,AL} + \dot{Q}_{trans,Grund} + \dot{Q}_{inf},$$

wobei

$$\dot{Q}_{trans,AL} = u_{trans,AL} * A_{A,AL} * \left(\overline{\vartheta}_{innen,AL} - \overline{\vartheta}_{A}\right)$$

$$\dot{Q}_{trans,Grund} = u_{trans,Grund} * A_{A,Grund} * \left(\overline{\vartheta}_{innen,Grund} - \overline{\vartheta}_{Grund}\right)$$

$$\dot{Q}_{inf} = u_{inf,AL} * A_{A,AL} * \left(\overline{\vartheta}_{innen,AL} - \overline{\vartheta}_{A}\right) + u_{inf,IL} * A_{A,AL} * \left(\overline{\vartheta}_{innen,IL} - \overline{\vartheta}_{A}\right) + u_{inf,Grund} * A_{A,AL} * \left(\overline{\vartheta}_{innen,Grund} - \overline{\vartheta}_{A}\right)$$

bzw.

$$\dot{Q}_{inf} = \left(u_{inf,AL} + u_{inf,IL} + u_{inf,Grund}\right) * A_{A,AL} * \left(\overline{\vartheta}_{innen} - \overline{\vartheta}_{A}\right) = u_{inf} * A_{AL} * \left(\overline{\vartheta}_{innen} - \overline{\vartheta}_{A}\right).$$

Für die in den vorstehenden Gleichungen vorkommenden Formeln gilt

| | |
|---|---|
| $u_{trans,AL}$ | Wärmedurchgangskoeffizient, bezogen auf die Außenfläche $A_{A,AL}$ der Außenluft berührenden Gebäudeteile [W/K*m²]; |
| $A_{A,AL}$ | Außenfläche der Außenluft berührenden Gebäudeteile [m²]; |
| $(\overline{\vartheta}_{innen,AL} - \overline{\vartheta}_{A})$ | mittlere Temperaturdifferenz zwischen Innenluft- und Außenlufttemperatur der Räume, die Außenwände mit Außenluftkontakt aufweisen [K]; |
| $u_{trans,Grund}$ | Wärmedurchgangskoeffizient, bezogen auf die Außenfläche $A_{A,Grund}$ der Erdreich berührenden Gebäudeteile [W/K*m²]; |
| $A_{A,Grund}$ | Außenfläche der Erdreich berührenden Gebäudeteile [m²]; |
| $(\overline{\vartheta}_{innen,Grund} - \overline{\vartheta}_{Grund})$ | mittlere Temperaturdifferenz zwischen Innenlufttemperatur und Erdreicherdreichtemperatur der Räume, die Außenwände mit Erdkontakt aufweisen [K]; |
| $u_{inf,AL}$ | Lüftungswärmeverlustkoeffizient für außen liegende Räume (bezogen auf die Außenfläche $A_{A,AL}$ der Außenluft berührenden Gebäudeteile) [W/K*m2]; |
| $u_{inf,IL}$ | Lüftungs-Wärmeverlustkoeffizient für innen liegende Räume (bezogen auf die Außenfläche $A_{A,AL}$ der Außenluft berührenden Gebäudeteile) [W/K*m2]; |
| $u_{inf,Grund}$ | Lüftungswärmeverlustkoeffizient für außen liegende Räume mit Erdkontakt (bezogen auf die Außenfläche $A_{A,AL}$ der Außenluft berührenden Gebäudeteile) [W/K*m2]; |

$(\overline{\vartheta}_{\text{innen},IL} - \overline{\vartheta}_A)$ mittlere Temperaturdifferenz zwischen Innenluft- und Außenlufttemperatur der innen liegenden Räume [K];

$(\overline{\vartheta}_{innen,Grund} - \overline{\vartheta}_A)$ mittlere Temperaturdifferenz zwischen Innenluft- und Außenlufttemperatur der Räume, die Außenwände mit Erdkontakt aufweisen [K];

$(\overline{\vartheta}_{innen} - \overline{\vartheta}_A)$ mittlere Temperaturdifferenz zwischen Innenluft- und Außenlufttemperatur aller Räume [K];

$u_{\text{inf}}$ Lüftungswärmeverlustkoeffizient des Gebäudes, bezogen auf die an die Außenluft angrenzende Außenfläche $A_{A,AL}$ [W/K*m$^2$].

Berücksichtigt man, dass der Gebäudewärmeverlust aus der Differenz zwischen Innentemperaturen und den Umgebungstemperaturen (Außenluft- und Erdreichtemperatur) resultiert, kann für den Gesamtwärmeverlust des Gebäudes, d.h. die für die Raumheizung aufgewendete Wärmemenge, geschrieben werden:

$$\dot{Q}_{Verlust} = \dot{Q}_{trans,Grund} + \dot{Q}_A ,$$

mit

$\dot{Q}_{trans,Grund}$ außenlufttemperaturunabhängiger Gebäudewärmeverlust [W],
$\dot{Q}_A$ außenlufttemperaturabhängiger Gebäudewärmeverlust [W].

Hierbei sind:

$$\dot{Q}_{trans,Grund} = u_{trans,Grund} * A_{A,Grund} * \left( \overline{\vartheta}_{innen,Grund} - \overline{\vartheta}_{Grund} \right)$$

$$\dot{Q}_A = \dot{Q}_{trans,AL} + \dot{Q}_{\text{inf}}$$

und

$$\dot{Q}_{trans,AL} = u_{trans,AL} * A_{A,AL} * \left( \overline{\vartheta}_{innen,AL} - \overline{\vartheta}_A \right).$$

$$\dot{Q}_{\text{inf}} = \dot{Q}_{\text{inf},AL} + \dot{Q}_{\text{inf},IL} + \dot{Q}_{\text{inf},Grund} = u_{\text{inf}} * A_{A,AL} * \left( \overline{\vartheta}_{innen} - \overline{\vartheta}_A \right).$$

Somit folgt für den außenlufttemperaturabhängigen Gebäudewärmeverlust:

$$\dot{Q}_A = u_{trans,AL} * A_{A,AL} * \left( \overline{\vartheta}_{innen,AL} - \overline{\vartheta}_A \right) + u_{\text{inf}} * A_{A,AL} * \left( \overline{\vartheta}_{innen} - \overline{\vartheta}_A \right)$$

Der außentemperaturabhängige Wärmeverlust ergibt sich also als Größe, die von dem zeitinvarianten Transmissionswärmedurchgangskoeffizienten $u_{trans,AL}$ und dem zeitvarianten Lüftungswärmeverlustkoeffizient $u_{\text{inf}}$ abhängt.

Letzterer ist definiert als $u_{\text{inf}} = u_{\text{inf},AL} + u_{\text{inf},IL} + u_{\text{inf},Grund}$. Die gemittelte Innentemperatur kann durch

$$\overline{\vartheta}_{innen} = \frac{\sum\limits_{k} A_{N,AL,k} \cdot \vartheta_{innen,AL,AV,k}}{\sum\limits_{k} A_{N,AL,k}} + \frac{\sum\limits_{l} A_{N,IL,k} \cdot \vartheta_{innen,IL,AV,l}}{\sum\limits_{l} A_{N,IL,l}} + \frac{\sum\limits_{m} A_{N,Grund,m} \cdot \vartheta_{innen,Grund,AV,m}}{\sum\limits_{m} A_{N,Grund,m}}$$

oder durch

$$\vartheta_{innen,AV} = \overline{\vartheta}_{innen} = \frac{1}{\sum_{k} A_{N,k}} \sum_{k} A_{N,k} \cdot \vartheta_{innen,AV,k}$$

abgeschätzt werden. Für die vorstehenden Gleichungen gelten die folgenden Definitionen:

$u_{trans,AL}$ ... Wärmedurchgangskoeffizient, bezogen auf die Außenfläche AAL der Außenluft berührenden Gebäudeteile [W/K*m²];

$u_{inf}$ ... Lüftungswärmeverlustkoeffizient des Gebäudes, bezogen auf die Außenfläche AAL der Außenluft [W/K*m²];

$A_{A,AL}$ ... Außenfläche der Außenluft berührenden Gebäudeteile [m²];

$\overline{\vartheta}_{A}$ über $\Delta_t$ zeitlich gemittelte Außentemperatur [°C];

$\overline{\vartheta}_{innen,AL}$ ... über $\Delta_t$ zeitlich gemittelte Innenlufttemperatur der Räume, die Außenwände mit Außenluftkontakt aufweisen [K];

$\overline{\vartheta}_{innen,IL}$ ... über $\Delta_t$ zeitlich gemittelte Innenlufttemperatur der innen liegenden Räume [°C];

$\overline{\vartheta}_{innen,Grund}$ ... über $\Delta_t$ zeitlich gemittelte Innenlufttemperatur der Räume mit Erdkontakt [°C];

$\overline{\vartheta}_{innen,Grund}$ ... über $\Delta_t$ zeitlich gemittelte Innenlufttemperatur aller Räume [°C];

$\vartheta_{innen,AV,k}$ ... über $\Delta_t$ zeitlich gemittelte Innentemperatur des Raumes k [°C];

$\Delta_t$ ... Messzeitraum;

$A_{N,k}$ ... Nutzfläche des Raumes k [m²];

$A_{N,AL,k}$ ... Nutzfläche des Raumes k mit außenliegenden Wänden [m²]

$A_{N,IL,k}$ ... Nutzfläche des Raumes k mit nur innenliegenden Wänden [m²]

$A_{N,Grund,k}$ ... Nutzfläche des Raumes k mit Grundkontakt [m²].

Diese vorstehenden Definitionen haben insbesondere Gültigkeit für den gesamten Text, besonders in Abgrenzung der verschiedenen Größen zueinander.

Wird nun die partielle Ableitung des Gesamtwärmeverlustes des Gebäudes nach der Außentemperatur bei etwa gleich bleibender Innentemperatur gebildet, d.h. die Ableitung der für die Raumheizung aufwendeten Wärmemenge, folgt:

$$\frac{\partial}{\partial \vartheta_A}\left(\dot{Q}_{Verlust}\right) = \frac{\partial}{\partial \vartheta_A}\left(\dot{Q}_A + \dot{Q}_{Grund}\right) = \frac{\partial}{\partial \vartheta_A}\left(\dot{Q}_A\right),$$

$$\frac{\partial}{\partial \vartheta_A}\left(\dot{Q}_{Grund}\right) = 0 .$$

da $\dot{Q}_{Grund}$ außenlufttemperaturunabhängig ist und somit gilt:

Unter Berücksichtigung von

$$\dot{Q}_A = u_{trans,AL} * A_{A,AL} * \left(\overline{\vartheta}_{innen,AL} - \overline{\vartheta}_A\right) + u_{inf} * A_{A,AL} * \left(\overline{\vartheta}_{innen} - \overline{\vartheta}_A\right).$$

folgt weiter:

$$\frac{\partial}{\partial \vartheta_A}\left(\dot{Q}_{Verlust}\right) = \frac{\partial}{\partial \vartheta_A}\left(\dot{Q}_A\right) = -\left(u_{trans,AL} + u_{inf}\right) * A_{A,AL}$$

bzw.

$$\frac{\partial}{\partial \vartheta_A}\left(\dot{Q}_{Verlust}\right) = \frac{\partial}{\partial \vartheta_A}\left(\dot{Q}_A\right) = -u_A * A_{A,AL} ,$$

und damit

$$u_A = u_{trans,AL} + u_{\inf} ,$$

wobei $u_A$ der außentemperaturabhängige Gesamtwärmeverlustkoeffizient ist, bezogen auf die Außenfläche $A_{A,AL}$ der Außenluft berührenden Gebäudeteile [W/K*m²].

Damit lässt sich also der Gesamtwärmeverlustkoeffizient $u_A$ aus der Ableitung der für die Raumheizung aufgewendete Wärmemenge nach der Außentemperatur auf einer Art und Weise rechnerisch ermitteln.

Werden über einen Zeitraum $\Delta_t$ die folgenden Größen messtechnisch erfasst:

$\Delta Q_{RH} = \Delta Q_{Verlust} - \Delta Q_{Gewinne}$ ... erfasste Wärmemenge, aufgewendet für Beheizung aller Räume (ohne Warmwasserbereitung) [kWh] unter Berücksichtigung interner oder auch solarer Gewinne, z.B. ermittelt durch die Anzeige am Hauptwärmezähler für Raumheizung;

$\overline{\vartheta_{AL}}$ ... über $\Delta_t$ gemittelte Außenlufttemperatur [°C];

$\overline{\vartheta_{innen}}$ ... über $\Delta_t$ gemittelte Temperaturen der Innenluft aller Räume [°C];

$\Delta_t$ ... Messintervall, beispielsweise eine Heizperiode, ein Monat, ein Tag, eine Stunde, etc.,

so kann unter Berücksichtigung, dass die Wärmegewinne außentemperaturunabhängig sind, mit

$$\frac{\partial}{\partial \vartheta_A}\left(\dot{Q}_{RH}\right) = \frac{\partial}{\partial \vartheta_A}\left(\dot{Q}_{Verlust} - \dot{Q}_{Gewinne}\right) = \frac{\partial}{\partial \vartheta_A}\left(\dot{Q}_{Verlust}\right) = \frac{\partial}{\partial \vartheta_A}\left(\dot{Q}_A\right) = -u_A * A_{A,AL}$$

der Gesamtwärmeverlustkoeffizient $u_A$ ermittelt werden.

Wie nachfolgend dargestellt, kann der Gesamtwärmeverlustkoeffizient erfindungsgemäß ferner auf folgende zwei Arten rechnerisch und/oder graphisch ermittelt werden.

Die erste Ermittlung erfolgt rechnerisch, wobei beispielsweise stündlich oder in anderen Messintervallen $\Delta_t$ die folgenden Größen bestimmt werden:

$$\hat{\dot{Q}}_{Verlust} = \hat{\dot{Q}}_{RH} \approx \frac{\Delta Q_{RH}}{\Delta t}$$

- mittleren Beheizungsleistung:

$$\overline{\vartheta}_A = \frac{1}{I} \sum_i \vartheta_{A,i}$$

- mittleren Außentemperatur:

Für Perioden mit annähernder konstanter mittlerer Innentemperatur $\overline{\vartheta_{innen}}$ werden dann die zeitlichen Ableitungen der für die Raumheizung aufgewendete Wärmemenge und der Außentemperatur ermittelt:

$$\frac{\Delta}{\Delta t}\left(\hat{\dot{Q}}_{Verlust}\right) = \frac{\Delta}{\Delta t}\left(\hat{\dot{Q}}_{RH}\right) \approx \frac{\Delta}{\Delta t}\left(\frac{\Delta Q_{RH}}{\Delta t}\right)$$

$$\frac{\Delta}{\Delta t}\left(\overline{\vartheta}_A\right)$$

Aus den über das Messintervall $\Delta_t$ ermittelten Werten können ferner die partiellen Ableitungen nach der Außentemperatur bestimmt werden:

$$\frac{\Delta}{\Delta \vartheta_A}\left(\hat{\dot{Q}}_{Verlust}\right) \approx \frac{\dfrac{\Delta}{\Delta t}\left(\dfrac{\Delta Q_{RH}}{\Delta t}\right)}{\dfrac{\Delta}{\Delta t}\left(\overline{\vartheta}_A\right)}$$

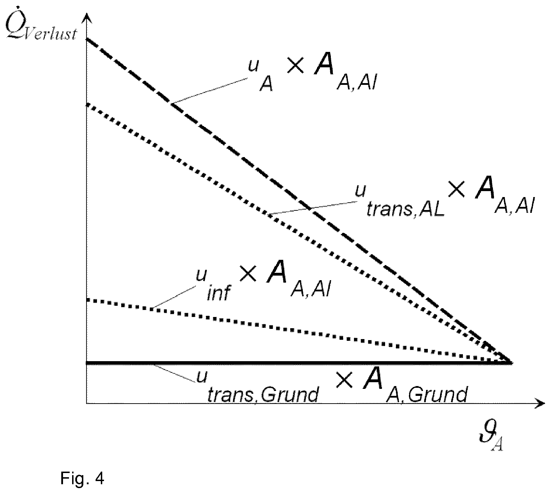

Alternativ oder zusätzlich ist die Ermittlung von $\frac{\Delta}{\Delta\vartheta_A}\left(\hat{\dot{Q}}_{Verlust}\right)$ erfindungsgemäß auch grafisch sehr einfach möglich, indem die Verlustleistung über der Außentemperatur in regelmäßigen oder auch zufälligen Zeitpunkten aufgetragen wird und aus der resultierenden Punktwolke die Grafik in Fig. 4 gebildet wird. $\frac{\Delta}{\Delta\vartheta_A}\left(\hat{\dot{Q}}_{Verlust}\right)$ ist der Betrag des negativen Anstiegs der in Fig. 4 linearisierten Kennlinie $\hat{\dot{Q}}_{Verlust}$ über $\Delta\vartheta_A$.

Ferner können erfindungsgemäß alternativ und/oder zusätzlich direkt die partiellen Ableitungen aus den über das Messintervall $\Delta_t$ ermittelten Werten mittels Verhältnisbildung der Änderungen der Werte ermittelt werden:

$$\frac{\Delta}{\Delta\vartheta_A}\left(\hat{\dot{Q}}_{Verlust}\right) \approx \frac{\Delta\left(\frac{\Delta Q_{RH}}{\Delta t}\right)}{\Delta\left(\overline{\vartheta}_A\right)}$$

Für jede der vorstehenden Möglichkeiten ergibt sich der Gesamtwärmeverlustkoeffizient aus der folgenden Beziehung:

$$u_A = \left(u_{trans,AL} + u_{inf}\right) \approx -\left(\frac{\frac{\Delta}{\Delta t}\left(\frac{\Delta Q_{RH}}{\Delta t}\right)}{\frac{\Delta}{\Delta t}\left(\overline{\vartheta}_A\right)}\right) / A_{A,AL} \; .$$

Da der Transmissionswärmedurchgangskoeffizient $u_{trans,AL}$ annähernd konstant, d.h. zeitinvariant ist, und der Lüftungswärmeverlustkoeffizient $u_{inf}$ zeitvariant sein muss sowohl wegen zeitabhängigem Lüftungsverhalten der Nutzer als auch wegen zeitvarianter Windlast und daraus resultierendem zeitvarianten mittlerem Luftwechsel $\lambda_{LW}$ im Gebäude, wird erfindungsgemäß ausgenutzt, dass der Transmissionswärmedurchgangskoeffizient $u_{trans,AL}$ außentemperaturunabhängig und somit für alle Messwerte und Messperioden praktisch gleich sein muss. Der minimale außentemperaturunabhängige Wärmeverlustkoeffizient min($u_{AL}$) ergibt sich also aus der Summe des Transmissionswärmekoeffizienten $u_{trans,AL}$ und des minimalen Lüftungswärmeverlustkoeffizienten min($u_{inf}$), der bei minimalem mittleren Luftwechsel im Gebäude theoretisch abgeschätzt werden kann, zu

$$\min\left(u_A\right) = u_{trans,AL} + \min\left(u_{inf}\right).$$

Für die Abschätzung des außentemperaturunabhängigen Transmissionswärmekoeffizienten $u_{trans,AL}$ folgt schließlich:

$$u_{trans,AL} = \min\left(u_A\right) - \min\left(u_{inf}\right),$$

mit

min($u_A$)　　... kleinster Wert von $u_A$ über mehrere Messintervalle und
min($u_{inf}$)　　... geschätzter kleinster Lüftungswärmeverlustkoeffizient mit minimaler Luftwechselrate $\lambda_{LW,min}$.

Der kleinste geschätzte Lüftungswärmeverlustkoeffizient kann abgeschätzt werden zu

$$\min\left(u_{\inf}\right) = \frac{c_{Luft} * \rho_{Luft} * \overline{h}_{NE} * \lambda_{LW,\min} * \sum_{k} A_{N,k}}{A_{A,AL}}$$

mit

$\lambda_{LW,\min}$ ... minimaler mittlerer Luftwechsel im Gebäude [1/h] (In Abhängigkeit des Gebäudedämmstandards kann beispielsweise gesetzt werden: $\lambda_{LW,\min,EnEV} = 0{,}1 \: / \: h$ ; $\lambda_{LW,\min,WSV\,95} = 0{,}2 \: / \: h$ ; $\lambda_{LW,\min,alteGebäude} = 0{,}3 \: / \: h$.) und

$$\sum_{k} A_{N,k}$$

... Nutzfläche der Räume [m$^2$].

Aus der Kenntnis der außentemperaturunabhängigen Transmissionswärmekoeffizienten $u_{trans,AL}$ und des kleinsten geschätzten Lüftungswärmeverlustkoeffizienten min($u_{\inf}$) kann leicht auf den außentemperaturabhängigen und zeitlich variablen Lüftungswärmeverlustkoeffizienten geschlossen werden:

$$u_{\inf} = u_A - u_{trans,AL} \: .$$

Gemäß der zuvor beschriebenen Ausführungsformen der vorliegenden Erfindung, bei der der Transmissionswärmedurchgangs- und der Lüftungswärmeverlustkoeffizient auf Basis einer Raumheizwärmeerfassung rechnerisch ermittelt werden, kann der theoretische, von der Wärmeleitung der Gebäudehülle abhängige Transmissionswärmedurchgangskoeffizient $u_{trans,AL}$ aus Verbrauchsdaten ausreichend genau bestimmt werden, da zeitvariante Einflüsse wie Nutzerverhalten und Windlast erfindungsgemäß in dem zeitvarianten Lüftungswärmeverlustkoeffizienten $u_{\inf}$ abgebildet werden, der zusätzlich Rückschlüsse über das Nutzerverhalten zulässt und bei einem energetisch unsinnigen Verhalten entsprechende Hinweise an den Nutzer erlaubt, die auch automatisch durch Abgleich mit sinnvollen Nutzerprofilen erzeugt werden können.

Alternativ oder zusätzlich zur Überprüfung können der Transmissionswärmedurchgangskoeffizient $u_{trans,AL}$ und der Lüftungswärmeverlustkoeffizient $u_{\inf}$ auch graphisch bestimmt werden. Die wird nachfolgend mit Bezug auf Fig. 4 erläutert.

Analog zu der zuvor beschriebenen rechnerischen Ermittlung werden bei dieser Variante die mittlere Beheizungsleistung

$$\hat{\dot{Q}}_{Verlust} = \hat{\dot{Q}}_{RH} \approx \frac{\Delta Q_{RH}}{\Delta t}$$

und die mittlere Außentemperatur

$$\overline{\vartheta}_A = \frac{1}{I} \sum_{i} \vartheta_{A,i}$$

in vorzugsweise regelmäßigen Zeitintervallen vorzugsweise mit annähernd konstanten Innentemperaturen, bspw. stündlich ermittelt und graphisch wie in Fig. 4 dargestellt aufgetragen.

Die Grafik gemäß Fig. 4 zeigt also $\hat{\dot{Q}}_{RH} \approx \frac{\Delta Q_{RH}}{\Delta t}$ dargestellt versus $\overline{\vartheta}_A = \frac{1}{I} \sum_{i} \vartheta_{A,i}$ für Perioden mit annähernder konstanter mittlerer Innentemperatur $\overline{\vartheta}_{innen}$. Die Grafik verdeutlicht u.a., dass sich die Heizleistung aus einem außentemperaturunabhängigen $(\hat{\dot{Q}}_{RH,Grund})$ und einem außentemperaturabhängigen Teil $(\hat{\dot{Q}}_{RH,trans} + \hat{\dot{Q}}_{RH,\inf})$ zusammensetzt:

$$\hat{\dot{Q}}_{RH} = \hat{\dot{Q}}_{RH,Grund} + \hat{\dot{Q}}_{RH,trans} + \hat{\dot{Q}}_{RH,\inf} \: .$$

Die Steilheit der aus der Punktwolke $\left[ \hat{\dot{Q}}_{RH} ; \overline{\vartheta}_A \right]$ beispielsweise per Regression ermittelten Kennlinie $\dot{Q}_{RH}(\vartheta_A)$ der mit zunehmender Außentemperatur abnehmenden (beispielsweise stündlich ermittelten) mittleren Beheizungsleistung entspricht dem Produkt aus der Außenfläche der Außenluft berührenden Gebäudeteile ($A_{A,AL}$) und dem gesuchten negativen, außentemperaturabhängigen Gesamtwärmeverlustkoeffizienten - $u_A*A_{A,AL}$.

Teilt man den vorzeichenverkehrten Wert der Steilheit dieser Kennlinie durch die Außenfläche der Außenluft berührenden Gebäudeteile ($A_{A,AL}$), erhält man den gesuchten außentemperaturabhängigen Gesamtwärmeverlustkoeffizienten $u_A$, für den gilt:

$$u_A = u_{trans,AL} + u_{\inf} .$$

Unter Berücksichtigung von

$$u_{trans,AL} = \min(u_A) - \min(u_{\inf})$$

und

$$\min(u_{\inf}) = \frac{c_{Luft} * \rho_{Luft} * \overline{h}_{NE} * \lambda_{LW,\min} * \sum_i A_{N,i}}{A_{A,AL}}$$

erhält man aus den kleinsten Werten der Punktwolke den Wärmedurchgangskoeffizienten $u_{trans,AL}$.

Der Lüftungswärmeverlustkoeffizient $u_{\inf}$ ergibt sich dann grafisch aus der Beziehung

$$u_{\inf} = u_{AL} - u_{trans,AL} ,$$

wobei für die Ermittlung dieses Koeffizienten auch Zeiträume mit wechselnder Innentemperatur ausgewählt werden können. Diese Zeiträume werden typisch Lüftungsphasen bzw. Phasen mit reduzierter Heizleistung repräsentieren.

Damit lassen sich die gewünschten Größen in einfacher Weise auch graphisch mittels Auswerteprogrammen gewinnen.

Nachfolgend wird noch einmal die erfindungsgemäß verwendbare Messtechnik beschrieben:
Zu bestimmende Wärmemengen bzw. Wärmeverbräuche sind:

$\Delta Q_{Verlust} = \Delta Q_{RH}$ ... erfasste Wärmemenge, aufgewendet für Beheizung aller Räume (ohne Warmwasserbereitung) nach Wärmeerzeugung [kWh];

$\Delta_t$ ... Messzeitraum.

Die Wärmemenge $\Delta Q_{Verlust} = \Delta Q_{RH}$ kann vorzugsweise ermittelt werden durch eine zentral angebrachte Messeinrichtungen (Wärmezähler), die die in das Gebäude transportierte Wärmemenge $Q_{RH}$ erfasst (nach der Wärmeerzeugung). Alternativ kann die für die Raumbeheizung und ggfls. für die Warmwasserbereitung eingesetzte Brennstoffmenge erfasst werden (z.B. mittels Gaszähler oder Ölstandsmessung) und nach Abtrennung des Anteiles für Warmwasser unter Berücksichtigung des Kesselnutzungsgrades die Wärmemenge für Raumbeheizung wie folgt ermittelt werden:

$$Q_{RH} = v_{TW,RH} \cdot B_{RH} \cdot H$$

mit

$v_{TW,RH}$ ... Kesselnutzungsgrad für Raumheizung (z.B. 0,8);

$B_{RH}$ ... für die Raumbeheizung des Gebäudes eingesetzte Brennstoffmenge

$H$ ... unterer ($H_l$) oder oberer ($H_S$) (bei Brennwertkesseln) Heizwert.

Alternativ oder zusätzlich können auch dezentral angebrachte Messeinrichtungen eingesetzt werden, die die Wärmemengen oder Wärmeverbrauche der Heizsträngen (Rohrwärme), der Gebäudeteile (infolge Nutzertrennung) oder der Räume bzw. Wohnungen erfassen und in ihrer Summe das gesamte Gebäude erfassen.

Zur Ermittlung der mittleren Temperaturdifferenz $\overline{\Delta_\vartheta}$ für die relevanten Gebäudeteile wird zunächst die mittlere Gebäudeinnentemperatur ermittelt, indem die einzelnen Temperaturen aller Räume des Gebäudes erfasst werden. Zur Erfassung der Raumtemperaturen wird in jedem Raum eine Messeinrichtung verwendet. Hierbei sollte auf eine bereits vorhandene Messeinrichtung zurückgegriffen werden, zum Beispiel elektronische Heizkostenverteiler, die mit einem Sensor die Raumtemperatur erfassen, Temperatursensoren eines elektronischen Einzelraumregelungssystems oder Temperatursensoren von anderen Geräten (z.B. Rauchwarnmelder).

Wenn in einem Raum kein geeignetes Gerät zur Verfügung steht, so ist eine separate Messeinrichtung (elektronisches Thermometer) anzubringen. Nun werden durch oben dargestellte Rechenverfahren die erforderlichen mittleren Gebäudeinnentemperaturen gebildet.

Für die Durchführung des vorgeschlagenen Verfahrens kann also weitestgehend auf im Rahmen der Heizkostenverteilung und Rauchwarnmelderüberwachung installierte Messtechnik zurückgegriffen werden. Die erfassten Messwerte müssen lediglich geeignet ausgewählt und ausgewertet werden. Dies kann durch eine programmtechnisch entsprechend eingerichtete Recheneinheit erfolgen.

**Bezugszeichenliste:**

| | |
|---|---|
| $u_A$ | (außenluftabhängiger) Gesamtwärmeverlustkoeffizient |
| $u_{trans}$ | Transmissionswärmedurchgangskoeffizient |
| $u_{inf}$ | Lüftungswärmeverlustkoeffizient |
| $\Delta Q_{RH}$ | für die Raumheizung aufgewendete Wärmemenge, Gebäudewärmeverlust [kWh]; |
| $\dot{Q}_{Verlust}$ | Gebäudewärmeverlust als Wärmeleistung [kW]; |
| Z1 bis Z9 | Zimmer |
| $A_A$ | Außenfläche |
| $A_{A,AL}$ | Außenfläche der Außenluft berührenden Gebäudeteile |
| $A_{A,Grund}$ | Außenfläche der Erdreich berührenden Gebäudeteile |
| $\vartheta_A$ | Außentemperatur |
| $\vartheta_{Grund}$ | Erdreichtemperatur |
| $\vartheta_i$ | Innentemperatur (zur Ermittlung der verbrauchten Wärmemenge) |

Die verwendeten Indizes AL, IL, Grund bei den vorstehenden Größen bedeuten, dass die jeweiligen Größen auf Räume mit Außenluftkontakt (AL), auf innenliegende Räume (IL) bzw. auf Räume mit Erdkontakt (Grund) bezogen sind.

**Patentansprüche**

**1.** Verfahren zur Bestimmung eines Gebäudewärmebedarfs auf Basis von Wärmeverbrauchsdaten, bei dem ein Gesamtwärmeverlustkoeffizient ($u_A$) ermittelt wird, **dadurch gekennzeichnet, dass**

- der Gesamtwärmeverlustkoeffizient ($u_A$) ausgehend von einem gemessenen oder ermittelten Gebäudewärmeverlust ($\Delta Q_{RH}, \dot{Q}$) ermittelt wird und dass
- der Gesamtwärmeverlustkoeffizient ($u_A$) in einen zeitinvarianten Transmissionswärmedurchgangskoeffizient ($u_{trans}$), der die Wärmedurchlässigkeit der Gebäudehülle infolge Wärmeleitung berücksichtigt, und einen zeitvarianten Lüftungswärmeverlustkoeffizient ($u_{inf}$) aufgeteilt wird, der zeitlich abhängige Lüftungsverluste berücksichtigt, die das zeitlich abhängige Lüftungsverhalten der Nutzer sowie eine sich zeitlich ändernde Windlast oder sonstige zeitvariante, infiltrationsbedingte Störungsgrößen beinhalten,

wobei der Transmissionswärmedurchgangskoeffizient ($u_{trans}$) unter Verwendung des Gesamtwärmeverlustkoeffi-

zienten (min($u_A$)) und eines minimalen geschätzten Lüftungswärmeverlustkoeffizienten (min($u_{inf}$)) berechnet wird und wobei aus dem Gesamtwärmeverlustkoeffizient ($u_A$) und dem Transmissionswärmedurchgangskoeffizient ($u_{trans}$) der Lüftungswärmeverlustkoeffizient ($u_{inf}$) berechnet wird.

2. Verfahren nach Anspruch 1, **dadurch gekennzeichnet, dass** der Transmissionswärmedurchgangskoeffizient ($u_{trans}$) und der Lüftungswärmeverlustkoeffizient ($u_{inf}$) separat für Räume mit Außenluftkontakt und für Räume mit Erdkontakt berechnet wird.

3. Verfahren nach Anspruch 1 oder 2, **dadurch gekennzeichnet, dass** der Gesamtwärmeverlustkoeffizient ($u_A$) rechnerisch aus der Ableitung der für die Raumheizung aufgewandten Wärmemenge ($\Delta Q_{RH}$) pro Messintervall ($\Delta t$) nach der Außentemperatur ($\vartheta_A$) ermittelt wird.

4. Verfahren nach einem der vorhergehenden Ansprüche, **dadurch gekennzeichnet, dass** der Gesamtwärmeverlustkoeffizient ($u_A$) rechnerisch aus dem Verhältnis der zeitlichen Ableitung der für die Raumheizung aufgewandten Wärmemenge ($\Delta Q_{RH}$) pro Messintervall ($\Delta t$) und der zeitlichen Ableitung der Außentemperatur ($\vartheta_A$) ermittelt wird.

5. Verfahren nach einem der vorhergehenden Ansprüche, **dadurch gekennzeichnet, dass** der Gesamtwärmeverlustkoeffizient ($u_A$) graphisch durch Bestimmung des Anstiegs einer linearisierten Kennlinie der Verlustleistung

$(\hat{\dot{Q}}_{Verlust})$ über der Außentemperatur($\vartheta_A$) ermittelt wird.

6. Verfahren nach einem der vorhergehenden Ansprüche, **dadurch gekennzeichnet, dass** dassder minimale geschätzte Lüftungswärmeverlustkoeffizient (min($u_{inf}$)) aus dem Lüftungswärmeverlust ($\hat{\dot{Q}}_{inf}$) unter der Annahme eines in Abhängigkeit von einem Gebäudestandard gesetzten minimalen mittleren Luftwechsel im Gebäude bezogen auf das Verhältnis der Nutzfläche ($A_N$) aller Räume im Gebäude zu der Außenfläche ($A_{A,AL}$) der Außenluft berührenden Gebäudeteile abgeschätzt wird

7. Verfahren nach einem der vorhergehenden Ansprüche, **dadurch gekennzeichnet, dass** als zur Beheizung verwendete abgegebene Wärmemenge ($\Delta Q_{RH}$) die durch zentrale Messeinrichtungen erfassten Verbrauchsdaten verwendet werden.

8. Verfahren nach einem der vorhergehenden Ansprüche, **dadurch gekennzeichnet, dass** als zur Beheizung verwendete abgegebene Wärmemenge ($\Delta Q_{RH}$) die durch dezentrale Messeinrichtungen erfassten Verbrauchsdaten verwendet werden.

9. Verfahren nach einem der vorhergehenden Ansprüche, **dadurch gekennzeichnet, dass** zur Bestimmung des Transmissionswärmedurchgangskoeffizienten ($u_{trans}$) und des zeitvarianten Lüftungswärmeverlustkoeffizienten ($u_{inf}$) Messdaten aus stationären Systemzuständen ausgewählt werden.

10. Verfahren nach einem der vorhergehenden Ansprüche, **dadurch gekennzeichnet, dass** der zeitliche Verlauf des Lüftungswärmekoeffizienten ($u_{inf}$) beobachtet und aufgezeichnet wird.

11. Vorrichtung zur Bestimmung eines Gebäudewärmebedarfs auf Basis von Wärmeverbrauchsdaten, mit einer zentralen Erfassungs- und Verarbeitungseinheit, welche Schnittstellen zum Anschließen von Messeinrichtungen zur Ermittlung des Wärmeverbrauchs und eine Recheneinheit aufweist, welche dazu eingerichtet ist, die von den Messeinrichtungen erfassten Messdaten zu empfangen und weiterzuverarbeiten, indem ein Gesamtwärmeverlustkoeffizient ($u_A$) ermittelt wird, **dadurch gekennzeichnet, dass** die Recheneinheit dazu eingerichtet ist, das Verfahren gemäß einem der Ansprüche 1 bis 10 durchzuführen.

12. Vorrichtung nach Anspruch 11, **dadurch gekennzeichnet, dass** als Messeinrichtungen Wärmemengenzahler, Heizkostenverteiler und/oder Temperaturfühler an die Schnittstellen angeschlossen sind.

## Claims

1. A method for ascertaining a heat requirement of a building based upon heat consumption data, in which an overall heat loss coefficient ($u_A$) is determined, **characterized in that**

- the overall heat loss coefficient ($u_A$) is determined proceeding from a measured or determined building heat loss ($Q_{RH}$, $Q$), and that
- the overall heat loss coefficient ($u_A$) is divided into a time-invariant transmission heat throughput coefficient ($u_{trans}$), which considers the heat permeability of the building envelope due to heat conduction, and a time-variant ventilation heat loss coefficient ($u_{inf}$), which considers time-dependent ventilation losses, which comprise the time-dependent ventilation behavior of the user as well as a wind load that changes over time or some other time-variant, infiltration-induced disturbance variables,

wherein the transmission heat throughput coefficient ($u_{trans}$) is calculated using the overall heat loss coefficient ($\min(u_A)$) and a minimal estimated ventilation heat loss coefficient ($\min(u_{inf})$), and wherein the ventilation heat loss coefficient ($u_{inf}$) is calculated from the overall heat loss coefficient ($u_A$) and the transmission heat throughput coefficient ($u_{trans}$).

2. The method according to claim 1, **characterized in that** the transmission heat throughput coefficient ($u_{trans}$) and the ventilation heat loss coefficient ($u_{inf}$) are calculated separately for rooms with outside air contact and rooms with ground contact.

3. The method according to claim 1 or 2, **characterized in that** the overall heat loss coefficient ($u_A$) is computationally determined from deriving the heat quantity ($\Delta Q_{RH}$) expended for heating the room per measuring interval ($\Delta t$) based on the outside temperature ($\vartheta_A$).

4. The method according to one of the preceding claims, **characterized in that** the overall heat loss coefficient ($u_A$) is computationally determined from the ratio between the chronologically derived heat quantity ($\Delta Q_{RH}$) expended for heating the room per measuring interval ($\Delta t$) and the chronologically derived outside temperature ($\vartheta_A$).

5. The method according to one of the preceding claims, **characterized in that** the overall heat loss coefficient ($u_A$) is graphically determined by determining the rise in a linearized characteristic of the power loss ($Q_{loss}$) over the outside temperature ($\vartheta_A$).

6. The method according to one of the preceding claims, **characterized in that** the minimal estimated ventilation heat loss coefficient ($\min(u_{inf})$) is estimated from the ventilation heat loss ($Q_{inf}$) assuming a minimal average air change in the building set as a function of a building standard in relation to the ratio between the effective area ($A_N$) of all rooms in the building and the outer surface ($A_{A,\ AL}$) of the building parts contacting the outside air.

7. The method according to one of the preceding claims, **characterized in that** the consumption data acquired by centralized measuring devices are used as the emitted heat quantity ($\Delta Q_{RH}$) used for heating purposes.

8. The method according to one of the preceding claims, **characterized in that** the consumption data acquired by decentralized measuring devices are used as the emitted heat quantity ($\Delta Q_{RH}$) used for heating purposes.

9. The method according to one of the preceding claims, **characterized in that** measured data from stationary system states are selected for determining the transmission heat throughput coefficient ($u_{trans}$) and the time-variant ventilation heat loss coefficient ($u_{inf}$).

10. The method according to one of the preceding claims, **characterized in that** the chronological progression of the ventilation heat loss coefficient ($u_{inf}$) is observed and recorded.

11. A device for determining a heat requirement of a building based upon heat consumption data, with a central acquisition and processing unit, which has interfaces for connecting measuring devices for ascertaining the heat consumption and a computing unit set up to receive and further process the measured data acquired by the measuring device by determining an overall heat loss coefficient ($u_A$), **characterized in that** the computing device is set up to implement the method according to one of claims 1 to 10.

12. The device according to claim 11, **characterized in that** heat quantity counters, heat cost allocators and/or temperature sensors are connected to the interfaces as measuring devices.

**Revendications**

1. Procédé destiné à la détermination des besoins calorifiques d'un bâtiment sur la base de données de consommation calorifique, pour lequel un coefficient de perte calorifique totale ($U_A$) est déterminé, **caractérisé en ce que**

   - le coefficient de perte calorifique total ($U_A$) est déterminé à partir d'une perte de chaleur du bâtiment mesurée ou déterminée ($\Delta Q_{RH}, Q$) et **en ce que**
   - le coefficient de perte calorifique totale ($U_A$) est réparti dans un coefficient de transfert de chaleur de transmission invariant dans le temps ($U_{trans}$), qui tient compte de la perméabilité à la chaleur de l'enveloppe du bâtiment en raison de la conductibilité calorifique, et dans un coefficient de perte de chaleur par ventilation ($U_{inf}$) variant dans le temps, qui tient compte des pertes par ventilation en fonction du temps, qui comportent le comportement de ventilation en fonction du temps des utilisateurs ainsi qu'une charge due au vent variable dans le temps ou d'autres grandeurs perturbatrices variant dans le temps, conditionnées par l'infiltration,

   sachant que le coefficient de transfert de chaleur de transmission ($U_{trans}$) est calculé en utilisant le coefficient de perte calorifique totale minimal estimé ($\min(U_{inf})$) et un coefficient de perte de chaleur par ventilation estimé minimal ($\min(U_{inf})$) et
   sachant que le coefficient de perte de chaleur par ventilation ($U_{inf}$) est calculé à partir du coefficient de perte calorifique totale ($U_A$) et du coefficient de transfert de chaleur de transmission ($U_{trans}$).

2. Procédé selon la revendication 1, **caractérisé en ce que** le coefficient de transfert de chaleur de transmission ($U_{trans}$) et le coefficient de perte de chaleur par ventilation ($U_{inf}$) est calculé séparément pour les locaux avec contact de l'air extérieur et pour les locaux avec contact de la terre.

3. Procédé selon la revendication 1 ou 2, **caractérisé en ce que** le coefficient de perte calorifique totale ($U_A$) est déterminé mathématiquement à partir de la dérivation de la quantité de chaleur ($\Delta Q_{RH}$) utilisée pour le chauffage des locaux par intervalle de mesure ($\Delta t$) selon la température extérieure ($\vartheta_A$).

4. Procédé selon l'une quelconque des revendications précédentes, **caractérisé en ce que** le coefficient de perte calorifique total ($U_A$) est déterminé mathématiquement à partir du rapport entre la dérivation de temps de la quantité de chaleur ($\Delta Q_{RH}$) utilisée pour le chauffage des locaux par intervalle de mesure ($\Delta t$) et la dérivation de temps de la température extérieure ($\vartheta_A$).

5. Procédé selon l'une quelconque des revendications précédentes, **caractérisé en ce que** le coefficient de perte calorifique totale ($U_A$) est déterminé graphiquement par détermination de la montée d'une ligne caractéristique linéarisée de la puissance de perte ($Q_{perte}$) au-dessus de la température extérieure ($\vartheta_A$).

6. Procédé selon l'une quelconque des revendications précédentes, **caractérisé en ce que** le coefficient de perte de chaleur par ventilation estimé minimal ($\min(U_{inf})$) est estimé à partir de la perte de chaleur par ventilation ($Q_{inf}$) en admettant un changement d'air moyen minimal dans le bâtiment fixé en fonction d'une norme de bâtiment en se référant au rapport entre la surface utile ($A_N$) de tous les locaux dans le bâtiment et la surface extérieure ($A_{A,AL}$) des parties de bâtiment en contact avec l'air extérieur.

7. Procédé selon l'une quelconque des revendications précédentes, **caractérisé en ce que** les données de consommation saisies par les dispositifs de mesure centrales sont utilisées en tant que quantité de chaleur ($\Delta Q_{RH}$) délivrée utilisée pour le chauffage.

8. Procédé selon l'une quelconque des revendications précédentes, **caractérisé en ce que** les données de consommation saisies par les dispositifs de mesure décentralisés sont utilisées en tant que quantité de chaleur ($\Delta Q_{RH}$) délivrée utilisée pour le chauffage.

9. Procédé selon l'une quelconque des revendications précédentes, **caractérisé en ce que** des données de mesure sont sélectionnées à partir des états du système stationnaires pour déterminer le coefficient de transfert de chaleur de transmission ($U_{trans}$) et le coefficient de perte de chaleur par ventilation variant dans le temps ($U_{inf}$).

10. Procédé selon l'une quelconque des revendications précédentes, **caractérisé en ce que** le profil temporel du coefficient de chaleur par ventilation ($U_{inf}$) est observé et enregistré.

**11.** Dispositif destiné à la détermination d'un besoin calorifique d'un bâtiment sur la base de données de consommation calorifiques, avec une unité de saisie et de traitement centrale, laquelle comporte des interfaces pour raccordement de dispositifs de mesure pour la détermination de la consommation de chaleur et une unité de calcul, laquelle est agencée pour recevoir et continuer à traiter les données de mesure saisies par les dispositifs de mesure, dans lesquelles un coefficient de perte calorifique total ($U_A$) est déterminé, **caractérisé en ce que** l'unité de calcul est agencée pour exécuter le procédé selon l'une quelconque des revendications 1 à 10.

**12.** Dispositif selon la revendication 11, **caractérisé en ce que** des compteurs de quantité de chaleur, des répartiteurs de frais de chauffage et/ou des sondes de température sont raccordés aux interfaces en tant que dispositifs de mesure.

Außentemperatur $\vartheta_{AL}$

Z3

$\dot{Q}_3 \sim \vartheta_{i,3} - \vartheta_{AL}$

| Z2 | Z9 | Z4 |

$\dot{Q}_2 \sim \vartheta_{i,2} - \vartheta_{AL}$ $\quad \dot{Q}_{transIL,9} \quad$ $\dot{Q}_4 \sim \vartheta_{i,4} - \vartheta_{AL}$

| Z1 | Z10 | Z5 |

$\dot{Q}_1 \sim \vartheta_{i,1} - \vartheta_{AL}$ $\qquad\qquad$ $\dot{Q}_5 \sim \vartheta_{i,5} - \vartheta_{AL}$

$A_{A,AL}$

| Z8 | Z7 | Z6 |

$\dot{Q}_8 \sim \vartheta_{i,8} - \vartheta_{Grund}$ $\quad \dot{Q}_7 \sim \vartheta_{i,7} - \vartheta_{Grund} \quad$ $\dot{Q}_6 \sim \vartheta_{i,6} - \vartheta_{Grund}$

$A_{A,Grund}$

Erdreichtemperatur $\vartheta_{Grund}$

Fig. 1

Gebäude $\qquad \vartheta_{i,3}$ $\qquad\qquad$ Außentemperatur
$\vartheta_a$

$\vartheta_{i,2}$ $\qquad$ $\vartheta_{i,4}$

$\vartheta_{i,1}$ $\qquad$ $\vartheta_{i,5}$

$\vartheta_{Vorlauf}$

zentrale Erfassungs-
und Verarbeitungseinheit

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20100012740 A1

- DE 10062581 A1